# DEMANDE DE BREVET EUROPEEN

(11) **EP 2 108 969 A1**
(43) Date de publication de la demande: **14.10.2009**
(21) Numéro de dépôt: 09155374.3
(22) Date de dépôt: 17.03.2009
(51) Int. Cl.: G01R 31/02, G01R 31/04, G01F 15/06

(54) **Dispositif électronique d'identification**

(30) Priorité: 10.04.2008 FR 0852421
(71) Demandeur: GDF SUEZ, 75008 Paris (FR)
(72) Inventeur: Haudeville, Marc, 75018 Paris (FR); Orthlieb, Sylvain, 75011 Paris (FR); Mangiapane, Jérôme, 94400 Vitry Sur Seine (FR)
(74) Mandataire: Thinat, Michel

(57) **Abrégé**

L'invention concerne un dispositif électronique d'identification pour identifier, parmi les conducteurs d'un câblage comprenant au moins deux conducteurs, au moins un conducteur relié en série à un interrupteur à commande magnétique et destiné à représenter une fonction électrique déterminée.

Le dispositif comprend un connecteur de test (7) ayant au moins deux broches destinées à être reliées à l'ensemble des conducteurs à tester, un microcontrôleur (2) pour commander, dans un ordre prédéterminé et en deux étapes, l'envoi d'un signal de test sur chacune des broches du connecteur de test (7) et pour effectuer les mesures et comparaisons nécessaires à l'identification des conducteurs, une source de signaux (3) reliée à la fois aux broches du connecteur de test (7) et au microcontrôleur (2), une source de champ magnétique (8) et un moyen d'affichage (4) pour l'affichage du résultat de l'identification.

## Description

La présente invention concerne un dispositif électronique d'identification pour identifier, parmi les conducteurs d'un câblage comprenant au moins deux conducteurs, au moins un conducteur relié en série à un interrupteur à commande magnétique et destiné à représenter une fonction électrique déterminée. La présente invention concerne également un procédé d'identification d'au moins un conducteur d'un câblage.

La présente invention est destinée par exemple au domaine du comptage de débits de fluides moyennant des compteurs.

L'information de comptage est une information primordiale pour la distribution de fluides, notamment dans le cadre d'un réseau comprenant un grand nombre de postes de livraison de ces fluides.

Ainsi, lorsque le fluide est un gaz, le volume de gaz consommé par chaque client, disponible en direct sur chaque compteur, peut être répété sous la forme d'une succession d'impulsions électriques. Le dispositif permettant cette répétition se nomme « émetteur basse fréquence » ou « prise basse fréquence » (prise BF). La prise BF se situe sur le boîtier du compteur et est donc facilement accessible pour tout agent ou technicien du distributeur de gaz. La succession d'impulsions peut être enregistrée et utilisée par différents types d'appareils tels que, par exemple, un appareil de télérelevé et un dispositif de suivi énergétique.

Au cours des interventions techniques sur les postes de livraison, les agents ou techniciens du distributeur du fluide sont amenés à devoir déterminer le câblage des prises BF des compteurs de gaz. Bien que des efforts aient permis de normaliser le câblage de ces prises, l'expérience quotidienne montre que le parc d'appareils n'est pas homogène en ce qui concerne le câblage des prises BF. Selon des statistiques récentes, environ 40% des échecs de télérelevé des données de consommation sont dus à un câblage non normalisé des prises BF.

L'émetteur basse fréquence se présente sous la forme d'un connecteur à plusieurs broches, souvent à six broches, ce qui explique son second nom « prise ». Généralement, deux broches représentent un interrupteur de comptage et deux autres broches représentent un interrupteur anti-fraude.

Toutefois, il est également concevable que, dans certains cas, une seule et même prise BF puisse avoir deux câblages de comptage et un câblage anti-fraude. Exemple: interrupteurs de comptage sur les broches 1-2; 3-5 et interrupteur anti-fraude sur les broches 4-6 d'une prise à six broches.

La prise BF a la particularité de contenir des interrupteurs à lames souples (ILS) commutant d'un état à l'autre par la présence d'un aimant devant le connecteur. De ce fait, le connecteur peut être configuré suivant deux cas de figure:
- absence de l'aimant: connecteur configuré en état de repos.
- présence de l'aimant: connecteur configuré en état actif

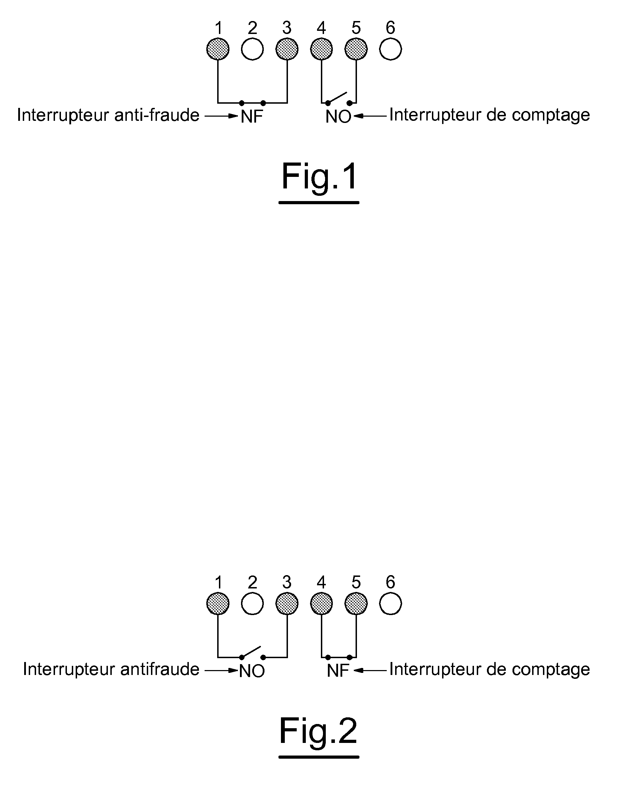

Il en découle les configurations suivantes pour la prise BF :
La prise est à l'état de repos: (configuration n°1)
   Dans ce cas, l'interrupteur anti-fraude est normalement fermé (NF) et l'interrupteur de comptage est normalement ouvert (NO). Sur le schéma représenté sur la figure 1, l'interrupteur anti-fraude se situe entre les broches 1 et 3 du connecteur et l'interrupteur de comptage entre les broches 4 et 5.
La prise passe à l'état actif: (configuration n°2)
   La présence d'un aimant devant le connecteur entraîne la commutation des interrupteurs à lame souple (ILS) présents au sein de la prise BF. L'interrupteur anti-fraude initialement fermé (NF) devient ouvert (0) et l'interrupteur de comptage initialement ouvert (NO) devient fermé (F). La prise passe ainsi à l'état actif (voir Figure 2).

L'installation de systèmes de télérelevé et de téléreport ou de tout autre dispositif utilisant les impulsions disponibles à la prise BF, est généralement assez simple. Cependant, le câblage peut être délicat à cause de sa diversité (pas de norme de câblage définie par les fabricants de compteurs) et de l'absence de schémas aux postes de livraison. L'agent ou le technicien est donc obligé de tester manuellement chacune des broches de la prise BF d'un compteur.

Cette détection ou identification des broches se fait en deux étapes:
- La première étape consiste à détecter ou identifier les broches anti-fraude. Cette détection est effectuée sans aucune intervention sur le compteur, celui-ci se trouvant à l'état de repos (état inverse de l'état de comptage) : les broches anti-fraude sont connectées et les broches de comptage sont déconnectées.
- La seconde étape consiste à détecter ou identifier les broches de comptage. Cette détection est effectuée après la mise en place d'un aimant devant la prise BF : les broches anti-fraude sont déconnectées et les broches de comptage sont connectées.

Cette identification fait perdre à l'agent ou au technicien beaucoup de temps, puisqu'il doit utiliser un multimètre et un aimant pour tester, pour l'ensemble des différentes combinaisons de broches possibles, la connexion entre deux broches différentes.

Le but de l'invention est de remédier aux inconvénients décrits ci avant et, plus particulièrement, de fiabiliser la pose des matériels utilisant une prise BF en s'assurant d'un câblage normalisé de cette dernière.

Plus particulièrement, le but de l'invention est de proposer une solution simple en matériel et en mise en oeuvre qui permette d'identifier sur une prise BF d'un compteur de fluide les broches représentant des fonctions prédéterminées, par exemple les interrupteurs anti-fraude et les interrupteurs de comptage.

Avantageusement, la solution matérielle consistera en un appareil portatif.

Le but de l'invention est atteint avec un dispositif électronique d'identification pour identifier, parmi les conducteurs d'un câblage comprenant au moins deux conducteurs, au moins un conducteur relié en série à un interrupteur à commande magnétique et destiné à représenter une fonction électrique déterminée.

Selon l'invention, le dispositif comprend un connecteur de test ayant au moins deux broches destinées à être reliées à l'ensemble des conducteurs à tester, un microprocesseur pour commander, dans un ordre prédéterminé et en deux étapes, l'envoi d'un signal de test sur chacune des broches du connecteur de test et pour effectuer les mesures et comparaisons nécessaires à l'identification, une source de signaux reliée à la fois aux broches du connecteur de test et au microprocesseur, une source de champ magnétique et un moyen d'affichage pour l'affichage du résultat de l'identification.

Le dispositif électronique assurant l'identification du brochage d'une prise BF repose sur un système composé d'un microcontrôleur et de plusieurs périphériques.

Le microcontrôleur, organe principal du dispositif, assure l'exécution d'un programme informatique permettant l'identification automatique du brochage de la prise BF et gère le pilotage de différents périphériques.

Les périphériques du dispositif d'identification sont généralement les suivants:
- un connecteur complémentaire en forme et en nombre de broches au connecteur de la prise BF de sorte que les agents du distributeur de fluide puissent brancher le dispositif électronique d'identification sur la prise BF ;
- un écran d'affichage pour indiquer des consignes à suivre par l'agent procédant à une identification des conducteurs d'un câblage et pour afficher le résultat de l'identification ;
- des interrupteurs, commutateurs et/ou boutons poussoirs assurant diverses fonctions telles que la mise sous tension de l'appareil, le démarrage de l'identification, la mise en présence d'un champ magnétique et/ou la confirmation de la présence d'un champ magnétique devant la prise BF et la remise à zéro du procédé d'identification.

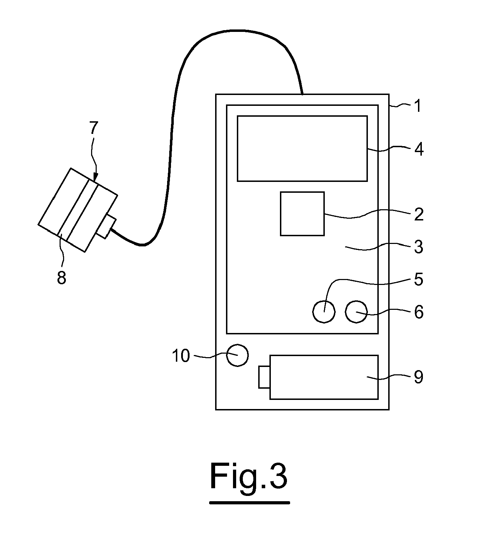

Dans le cas d'une réalisation selon l'exemple représenté dans les dessins (voir Figure 3), qui correspond à la plupart des réalisations envisagées, les périphériques du dispositif de l'invention sont les suivants :
- un connecteur DIN à six broches femelles, complémentaire au connecteur DIN à six broches mâles de la prise BF d'un compteur, de sorte que les agents puissent brancher le dispositif électronique d'identification sur la prise BF ;
- un afficheur LCD indiquant des consignes à suivre pour réaliser l'opération d'identification et affichant les couples de broches de l'interrupteur anti-fraude et ceux de l'interrupteur de comptage ; et
- plusieurs interrupteurs ou boutons poussoirs assurant la mise sous tension de l'appareil, le démarrage du procédé d'identification, la mise en présence d'un champ magnétique et/ou la confirmation de la présence d'un champ magnétique devant la prise BF et la remise à zéro du procédé d'identification.

Le but de l'invention est également atteint avec un procédé d'identification des conducteurs d'un câblage pour identifier, parmi au moins deux conducteurs du câblage, au moins un conducteur relié en série à un interrupteur à commande magnétique et destiné à représenter une fonction électrique déterminée, qui comprend les étapes suivantes :
- connecter chacun des conducteurs du câblage à identifier à une broche correspondante d'un connecteur de test d'un dispositif d'identification mettant en oeuvre ce procédé,
- commander en deux étapes et dans un ordre prédéterminé, l'envoi successif d'un signal de test sur chacune des broches du connecteur de test et effectuer les mesures et comparaisons nécessaires à l'identification,
- exposer les interrupteurs à commande magnétique des conducteurs à tester, pendant l'une ou l'autre des deux étapes d'envoi de signaux, à un champ magnétique,
- afficher le résultat de l'identification.

L'envoi successif d'un signal de test - de préférence sous la forme d'une impulsion - sur chacune des broches du connecteur de test et les mesures et comparaisons nécessaires à l'identification sont effectués selon des algorithmes mesurant et enregistrant pour chacune des broches du connecteur de test, les unes après les autres, les contacts avec une autre broche du connecteur de test. Ces envois d'impulsions et les mesures électriques qui les accompagnent sont effectués avantageusement pendant la première étape sans influence d'un champ magnétique sur les interrupteurs à commande magnétique des conducteurs à tester et pendant la seconde étape avec influence d'un champ magnétique sur les interrupteurs à commande magnétique des conducteurs à tester. Toutefois, il est également concevable, sans sortir du principe de la présente invention, que la première étape est effectuée sous l'influence d'un champ magnétique et que la seconde étape est effectuée sans influence d'un champ magnétique.

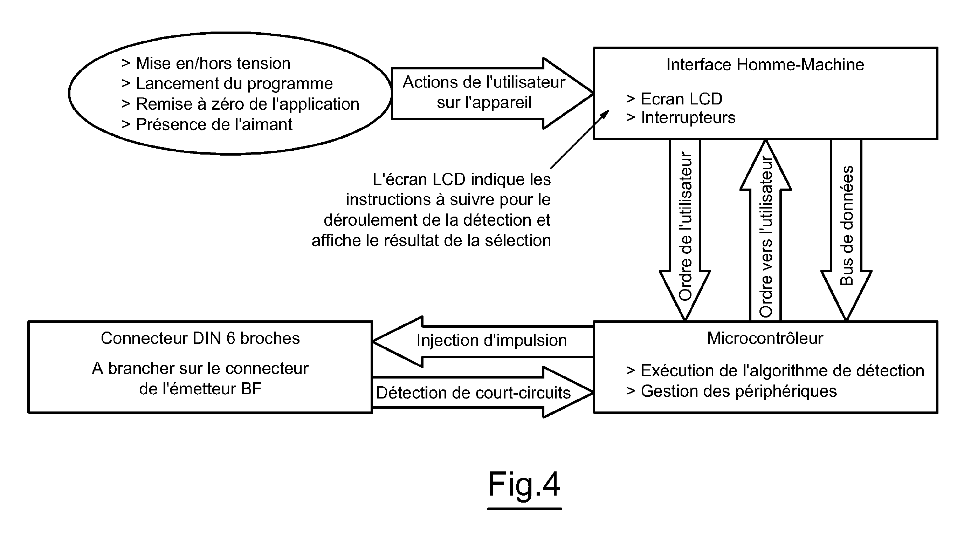

Le dispositif d'identification selon l'invention est utilisé de la manière suivante et comme représenté par le schéma fonctionnel visible sur la figure 4. Après avoir branché le dispositif sur la prise BF d'un compteur de fluide, l'agent procédant à l'identification met le dispositif sous tension et lance le procédé d'identification. Le compteur se trouve en état de repos (hors état de comptage), les broches anti-fraude sont connectées et les broches de comptage sont déconnectées. Le dispositif effectue alors une première étape d'identification selon un algorithme expliqué plus loin dans la présente description, pour identifier la ou les broches de la prise BF qui représentent une première fonction, par exemple un interrupteur anti-fraude. A cet effet, le dispositif d'identification envoie des impulsions successivement sur chacune des broches de la prise BF et repère les contacts anti-fraude potentiels. Il peut exister des courts-circuits entre les broches, et par conséquent le dispositif d'identification ne peut pas déduire de cette étape les broches anti-fraudes. Le dispositif d'identification mémorise, pour chaque broche, l'état des connections entre les différentes broches.

Ensuite, selon le mode de réalisation du dispositif utilisé, l'agent place un aimant devant la prise BF à l'endroit exact de l'interrupteur ou il active un électro-aimant intégré dans le connecteur du dispositif. Cette action a pour conséquence l'application d'un champ magnétique qui va agir sur les interrupteurs à lame souple. Ce dispositif permet de simuler l'état de comptage (broches anti-fraude déconnectées, broches de comptage connectées).

La confirmation de la présence d'un champ magnétique lance la seconde étape du procédé d'identification selon l'algorithme expliqué plus loin dans la présente description. Le dispositif d'identification envoie des impulsions successivement sur chacune des broches, repère les broches de comptage potentielles et compare les résultats obtenus aux deux étapes. Il en déduit quelles sont les broches anti-fraude et quelles sont les broches de comptage et affiche le résultat sur l'écran LCD.

Le dispositif d'identification peut par ailleurs être configuré de manière à afficher non seulement les actions à prendre par l'agent procédant à l'identification des broches, mais également des messages indiquant par exemple l'étape en cours de l'algorithme telle que « détection en cours » ou « analyse des résultats en cours ».

Dans la plupart des cas, les broches de la prise BF sont occupées par paires, c'est-à-dire l'interrupteur anti-fraude occupe deux broches et une ou deux autres paires de broches sont occupées par respectivement un ou deux interrupteurs de comptage.

Toutefois, la présente invention concerne également le cas où l'une ou plusieurs des fonctions représentées par les broches de la prise BF n'utilisent qu'une seule broche, le second contact étant établi par une broche commune ou par une masse électrique de la prise BF.

Sur le plan économique, le dispositif d'identification selon l'invention utilisé en tant que dispositif d'aide au câblage permet de fiabiliser la pose des dispositifs utilisant une prise BF. En assurant l'installation sur place du module sur la prise BF du compteur, les erreurs de câblage sont évitées et il ne sera pas nécessaire de revenir sur le site pour corriger la manipulation.

Une erreur de câblage nécessite l'intervention d'un technicien pendant environ 1h. L'expérience montre que 20% des échecs de pose sont dus à un mauvais câblage ce qui représente un coût de 1 à 2 millions d'Euro par an.

Contrairement à cela, un dispositif selon l'invention coûte de 200 à 300 Euro et peut ainsi permettre des économies considérables.

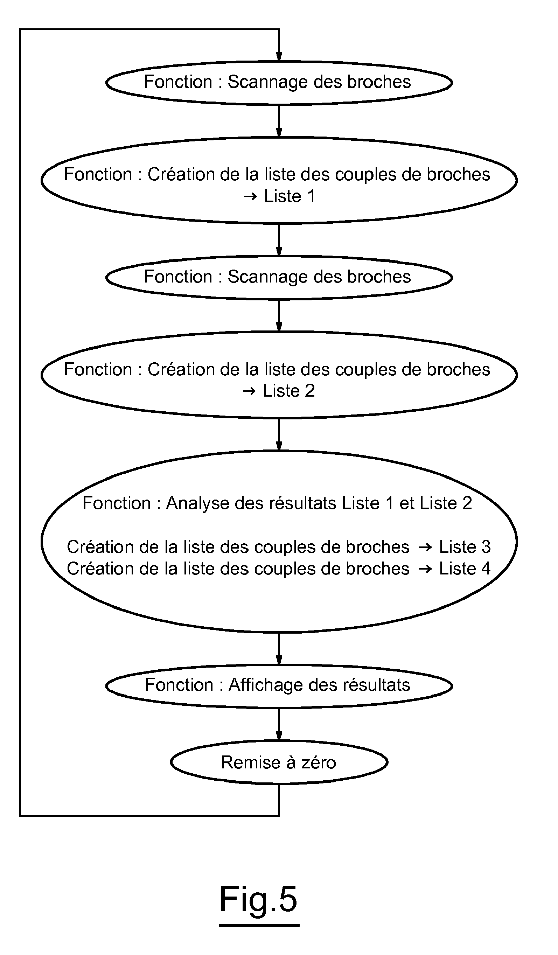

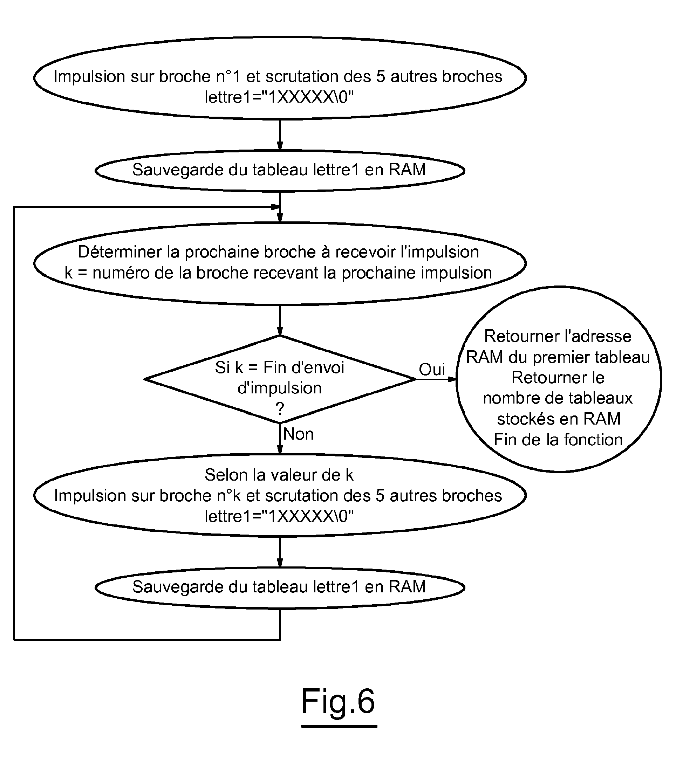

Le dispositif d'identification selon l'invention met en oeuvre deux algorithmes différents pour faire fonctionner le dispositif et pour effectuer l'identification, à savoir un algorithme général (voir Figure 5) et un algorithme de scannage (voir Figure 6).

### Le déroulement de l'algorithme général est le suivant :

Après le branchement du dispositif d'identification sur la prise BF à identifier et la mise sous tension du dispositif, l'agent appelle la fonction « scannage des broches » et fait exécuter la première étape du procédé d'identification des différentes broches de la prise BF. Cette première étape se déroule suivant l'algorithme de scannage décrit ci après. Le compteur dont la prise BF est à identifier, est alors en état de repos, ce qui permet d'identifier les broches entre lesquelles il y a une liaison électrique autre qu'un contact de comptage. Ces paires de broches sont enregistrées dans une liste 1.

Ensuite, le dispositif affiche à l'écran d'affichage un message indiquant à l'agent qu'il faut mettre en place l'aimant avant de faire dérouler la seconde étape. Après avoir disposé l'aimant devant la prise BF, l'agent confirme la mise en place de l'aimant en actionnant un bouton poussoir prévu à cet effet ou - le cas échéant - en agissant sur un écran tactile du dispositif. Une confirmation automatique par un détecteur de magnétisme est également concevable.

Par la mise en place de l'aimant, le compteur est en état de comptage, ce qui permet d'identifier les broches entre lesquelles il y a une liaison électrique de comptage. Ces paires de broches sont enregistrées dans une liste 2.

Si le dispositif d'identification selon l'invention est muni d'un électro-aimant, l'algorithme général comporte, à la place de l'étape d'affichage d'un message demandant la mise en place de l'aimant, une activation de l'électro-aimant avec - le cas échéant - une confirmation de l'activation.

Lorsque la liste 2 est complète, les différentes paires de broches sont comparées directement avec les différentes broches retenues dans la liste 1. Le résultat de cette comparaison est enregistré dans une liste 3 en ce qui concerne les paires de broches représentant la fonction d'interrupteur anti-fraude et dans une liste 4 en ce qui concerne les paires de broches représentant la fonction d'interrupteur de comptage.

L'algorithme général se termine avec l'affichage du résultat de l'identification des différentes broches de la prise BF.

### Le déroulement de l'algorithme de scannage est le suivant :

Après l'appel de la fonction « scannage des broches », des impulsions électriques sont données successivement sur chacune des broches de la prise BF. Selon l'exemple d'algorithme représenté sur la figure 6, la prise BF est pourvue de six broches. Toutefois, rappelons-le, car déjà indiqué plus haut, la présente invention n'est pas limitée à une application à des prises à six broches, mais s'applique à toute prise BF ayant un nombre pair ou impair de broches.

A chaque impulsion, le dispositif d'identification recherche et mémorise des courts-circuits entre la broche ayant reçu l'impulsion et les autres broches. Lorsqu'une broche scannée est en court-circuit avec la broche ayant reçu l'impulsion, l'état logique de la broche scannée est mis à « 1 ». Sinon, l'état logique de la broche scannée est mis à « 0 ». L'ensemble de ces états logiques est sauvegardé dans une mémoire RAM sous la forme d'un tableau « lettre 1 ».

Ensuite, l'algorithme choisit la broche suivante pour recevoir l'impulsion et pour attribuer des états logiques aux broches scannées selon la présence ou l'absence de courts-circuits, avec sauvegarde de l'ensemble de ces états dans la mémoire RAM sous la forme d'un tableau « lettre 2 ».

Cette action est alors répétée jusqu'à ce que chacune des broches de la prise BF ait été une fois choisie comme broche recevant une impulsion. Et l'ensemble des tableaux « lettre 1 » à « lettre k », k étant le nombre de broches de la prise BF, est sauvegardé dans la liste 1 mentionnée dans la description de l'algorithme général.

Pendant le déroulement de l'algorithme, une paire de broche déjà testée ne sera pas testée une seconde fois. De même, l'algorithme passe à la broche suivante, lorsque la broche envisagée n'est pas une broche à tester.

L'algorithme de scannage est utilisé à nouveau et se déroule de la même façon lors de la seconde étape du procédé d'identification des broches, c'est-à-dire après la mise en place d'un aimant ou l'activation d'un champ magnétique changeant l'état de fonctionnement du compteur auquel appartient la prise BF à identifier. Cette fois-ci, l'ensemble des tableaux « lettre 1 » à « lettre k » est sauvegardé dans la liste 2 mentionnée dans la description de l'algorithme général.

A la fin de l'algorithme, le dispositif de l'invention a sauvegardé toutes les paires de broches qui sont connectées entre elles.

D'autres caractéristiques et avantages de la présente invention ressortiront de la description ci-après d'un mode de réalisation d'un dispositif électronique d'identification selon l'invention. La description est faite en référence aux dessins dans lesquels
la figure 1 représente un exemple de branchement d'une prise BF à six broches en état de repos d'un compteur sur lequel est installée une prise BF,
la figure 2 représente l'exemple de branchement de la figure 1 en état actif d'un compteur sur lequel est installée une prise BF,
la figure 3 représente schématiquement la configuration d'un dispositif d'identification selon l'invention,
la figure 4 représente le schéma fonctionnel d'un dispositif d'identification selon l'invention,
la figure 5 représente l'algorithme général utilisé par les dispositifs d'identification selon l'invention et
la figure 6 représente l'algorithme de scannage utilisé par les dispositifs d'identification selon l'invention.

Alors que les figures 1, 2 et 4 à 6 se réfèrent à des parties de description données plus haut, la figure 3 est commentée ici.

La figure 3 représente un des différents modes de réalisation possibles d'un dispositif électronique d'identification selon l'invention, sous la forme d'un appareil portatif pour l'identification du brochage d'une prise BF d'un compteur à gaz.

L'appareil comprend un boîtier 1 dans lequel sont logés un microcontrôleur 2 destiné à assurer l'exécution d'algorithmes permettant l'identification automatique des broches d'une prise BF, une carte électronique 3 sur laquelle sont placés le microcontrôleur 2 et d'autres éléments électroniques et des éléments électriques nécessaires au fonctionnement du dispositif, un écran d'affichage 4, par exemple un écran LCD, tactile ou non, et des interrupteurs pour la mise sous tension et hors tension de l'appareil, le démarrage de l'identification, l'activation d'un champ magnétique ou la confirmation de la mise en place d'un aimant, la remise à zéro des algorithmes d'identification etc. La figure 3 ne représente que deux interrupteurs 5, 6.

L'appareil comprend en outre un connecteur de test 7 à broches femelles avec un électro-aimant 8 intégré dans le connecteur. Le fait que le connecteur de test comporte des broches femelles est lié à l'équipement des compteurs avec une prise BF à broches mâles. Il va de soi qu'un équipement inverse, où le compteur est équipé d'une prise BF à broches femelles et où l'appareil comporte donc un connecteur de test à broches mâles, est également couvert par la présente invention. Dans le même esprit, le nombre de broches des prises et des connecteurs de test n'est pas limité par l'invention. Pour un compteur de gaz, ce nombre est généralement six.

L'appareil comprend également une source électrique 9. La source électrique 9 est avantageusement une pile, rechargeable ou non, et sert à alimenter en électricité les différents éléments du dispositif d'identification et à fournir des impulsions de mesure lors de l'identification des différentes broches de la prise BF. Toutefois, la source électrique 9 peut également comprendre, en plus ou tout seul, un branchement pour une alimentation extérieure ou pour le raccordement d'un chargeur de batterie (pour la pile rechargeable) ou le raccordement de l'appareil à une prise électrique (par exemple la prise allume-cigare) d'un véhicule d'intervention utilisé par l'agent opérant l'identification.

Selon des variantes de réalisation du dispositif de l'invention, l'appareil peut comprendre l'une au moins des caractéristiques ci-après considérées isolément ou en une combinaison quelconque :
le champ magnétique est produit par un aimant permanent avantageusement attaché au boîtier 1 par un cordon ;
l'appareil est équipé d'une lampe ou d'une diode lumineuse 10 pour éclairer la prise BF ;
les interrupteurs et/ou boutons-poussoirs sont retro-éclairés ;
l'appareil est réalisé selon les critères à respecter en zones explosives.

## Revendications

1. Dispositif électronique d'identification pour identifier, parmi les conducteurs d'un câblage comprenant au moins deux conducteurs, au moins un conducteur relié en série à un interrupteur à commande magnétique et destiné à représenter une fonction électrique déterminée,
**caractérisé en ce qu'**il comprend un connecteur de test (7) ayant au moins deux broches destinées à être reliées à l'ensemble des conducteurs à tester, un microcontrôleur (2) pour commander, dans un ordre prédéterminé et en deux étapes, l'envoi d'un signal de test sur chacune des broches du connecteur de test (7) et pour effectuer les mesures et comparaisons nécessaires à l'identification des conducteurs, une source de signaux (3) reliée à la fois aux broches du connecteur de test (7) et au microcontrôleur (2), une source de champ magnétique (8) et un moyen d'affichage (4) pour l'affichage du résultat de l'identification.

2. Dispositif selon la revendication 1, **caractérisé en ce qu'**il comprend une source d'énergie électrique rechargeable (9).

3. Dispositif selon la revendication 1 ou 2, **caractérisé en ce que** la source de champ magnétique (8) est un aimant permanent.

4. Dispositif selon la revendication 1 ou 2, **caractérisé en ce que** la source de champ magnétique est un aimant électromagnétique (8) intégré dans le connecteur de test (7).

5. Dispositif selon l'une quelconque des revendications 1 à 4, **caractérisé en ce que** le moyen d'affichage (4) comprend un écran LCD.

6. Dispositif selon l'une quelconque des revendications 1 à 5, **caractérisé en ce que** le connecteur de test (7) est pourvu de broches femelles.

7. Dispositif selon l'une quelconque des revendications 1 à 6, **caractérisé en ce qu'**il comprend des moyens de commande électriques retro-éclairés (5, 6).

8. Procédé d'identification des conducteurs d'un câblage pour identifier, parmi au moins deux conducteurs du câblage, au moins un conducteur relié en série à un interrupteur à commande magnétique et destiné à représenter une fonction électrique déterminée,
**caractérisé par** les étapes suivantes :
connecter chacun des conducteurs du câblage à identifier à une broche correspondante d'un connecteur de test (7) d'un dispositif d'identification mettant en oeuvre ce procédé,
commander en deux étapes et dans un ordre prédéterminé, l'envoi successif d'un signal de test sur chacune des broches du connecteur de test (7) et effectuer les mesures et comparaisons nécessaires à l'identification,
exposer les interrupteurs à commande magnétique des conducteurs à tester, pendant l'une ou l'autre des deux étapes d'envoi de signaux, à un champ magnétique,
afficher le résultat de l'identification.

9. Procédé selon la revendication 8, **caractérisé en ce que** l'envoi successif d'un signal de test sur chacune des broches du connecteur de test (7) et les mesures et comparaisons nécessaires à l'identification sont effectués selon des algorithmes mesurant et enregistrant pour chacune des broches du connecteur de test (7), les unes après les autres, les contacts avec une autre broche du connecteur de test, et cela pendant la première étape sans influence d'un champ magnétique sur les interrupteurs à commande magnétique des conducteurs à tester et pendant la seconde étape avec influence d'un champ magnétique sur les interrupteurs à commande magnétique des conducteurs à tester.
